Europäisches Patentamt

European Patent Office

Office européen des brevets

(11) Numéro de publication: **0 146 429**
A1

## (12) DEMANDE DE BREVET EUROPEEN

(21) Numéro de dépôt: **84402204.6**

(22) Date de dépôt: **02.11.84**

(51) Int. Cl.⁴: **H 03 F 3/19**

(30) Priorité: **10.11.83 FR 8317924**

(43) Date de publication de la demande: **26.06.85**
**Bulletin 85/26**

(84) Etats contractants désignés: **AT BE CH DE FR GB IT LI LU NL SE**

(71) Demandeur: **TONNA ELECTRONIQUE, 36, avenue Hoche -Z.I.S.-E., F-51000 Reims (FR)**

(72) Inventeur: **Dumoulin, Gérard Roger Marcel, 3, rue de Varsovie, F-75210 Maizieres Les Metz (FR)**

(74) Mandataire: **Martin, Jean-Jacques et al, Cabinet REGIMBEAU 26, Avenue Kléber, F-75116 Paris (FR)**

(54) **Amplificateur large bande UHF notamment pour signaux de télévision et dispositif de traitement de signaux incorporant celui-ci.**

(57) La présente invention concerne un circuit amplificateur large bande de signaux électriques UHF réalisé de préférence en technologie hybride qui comprend au moins deux étages amplificateurs à transistors ($T_1$, $T_2$) non contre-réactionnés, un filtre d'entrée ($S_2$, $S_3$, $C_1$, $C_2$, $C_3$) et un filtre de sortie ($C_6$, $C_7$, $S_6$), lesdits filtres étant adaptés pour favoriser la transmission des signaux électriques de la bande UHF et atténuer au moins les signaux électriques de fréquence inférieure à cette bande UHF. Le circuit ainsi conçu présente notamment des caractéristiques de bruit, de gain et de linéarité améliorées par rapport aux réalisations antérieures.

EP 0 146 429 A1

AMPLIFICATEUR LARGE BANDE UHF NOTAMMENT POUR SIGNAUX
DE TELEVISION ET DISPOSITIF DE TRAITEMENT DE SIGNAUX
INCORPORANT CELUI-CI.

La présente invention concerne un circuit amplificateur de signaux électriques couvrant une large bande prédéterminée de fréquences.

La présente invention concerne plus précisément la transmission et l'amplification de signaux dans la bande dite UHF (Ultra-High Frequency) allant de 470 MHz à 960 MHz.

La présente invention s'applique en particulier à l'amplification de signaux de télévision, dont la largeur de bande couvre, pour chaque canal, plusieurs Megahertz.

L'invention sera décrite par la suite dans le cadre de cette application aux signaux de télévision sans que cette application toutefois puisse être considérée comme limitative.

D'une façon générale, il serait souhaitable de disposer de circuits amplificateurs large bande opérant dans la bande UHF.

Cela est en particulier le cas pour les signaux de télévision qui nécessitent très fréquemment une amplification pour permettre une bonne réception.

On a déjà proposé différents circuits amplificateurs à large bande notamment sous forme de circuits hybrides, adaptés pour la transmission de signaux de la bande UHF.

De tels circuits sont par exemple décrits dans le manuel "Wideband Transistors and Wideband Hybrid IC Modules", Sept. 81 édité par Philips.

On constate cependant, dans la pratique que les systèmes jusqu'ici proposés ne donnent pas entière satisfaction dans la mesure , en particulier, où leur facteur de bruit limite de façon importante leur utilisation dans les dispositifs de réception. De ce fait, il était nécessaire jusqu'ici, dans la plupart des cas d'adjoindre un étage supplémentaire à faible bruit associé à un ou plusieurs filtres limiteurs de bande.

La présente invention vient maintenant proposer un nouveau circuit amplificateur large bande de signaux électriques UHF qui présente en particulier des caractéristiques de bruit, de gain de transmission et de linéarité, sur toute la bande considérée, nettement améliorés par rapport aux réalisations antérieures.

A cet effet, la présente invention propose un circuit amplificateur large bande de signaux électriques UHF qui comprend au moins deux étages amplificateurs à transistors non contre-réactionnés, un filtre d'entrée et un filtre de sortie, lesdits filtres étant adaptés pour favoriser la transmission des signaux électriques de la bande UHF et atténuer au moins les signaux électriques de fréquence inférieure à cette bande UHF et les filtres d'entrée et de sortie étant des cellules asymétriques qui fixent respectivement l'impédance d'entrée et de sortie du circuit amplificateur sur toute la bande d'utilisation.

La Demanderesse a ainsi remarqué que en utilisant des étages amplificateurs à transistors non contre-réactionnés, à l'opposé des réalisations antérieures qui proposaient des contre-réactions sur lesdits étages amplificateurs, et dans la grande majorité des cas, des contre-réactions simultanément en tension et en cou-

3

rant, les caractéristiques de bruit et de gain des circuits amplificateurs étaient très nettement améliorées.

L'utilisation de cellules asymétriques fixant respectivement l'impédance d'entrée et de sortie du circuit amplificateur, est également essentielle selon l'invention.

Par ailleurs, selon une caractéristique avantageuse de la présente invention, les transistors des étages amplificateurs sont montés en émetteur commun.

Selon une autre caractéristique avantageuse de la présente invention et qui permet notamment d'obtenir une bonne linéarité du circuit amplificateur, en optimisant le gain aux fréquences élevées de la bande UHF, l'un au moins des étages amplificateurs comporte une charge réactive.

Dans le même but, il est avantageux qu'un circuit de couplage soit prévu entre les deux étages amplificateurs, ledit circuit de couplage comprenant une capacité qui relie la sortie de l'étage attaqué par le filtre d'entrée et la masse, d'une part, et d'autre part un circuit résonant série connecté entre la sortie de l'étage attaqué par le filtre d'entrée et l'entrée de l'autre étage amplificateur.

En outre, selon une caractéristique très importante de la présente invention, le circuit amplificateur précité est réalisé en technologie hybride. La réalisation des circuits amplificateurs précités, en technologie hybride, comme cela est proposé par la Demanderesse, permet en particulier de résoudre, avec une bonne reproductibilité, les problèmes de bruit, de gain et de linéarité jusqu'ici posés avec les circuits amplificateurs classiques.

Ainsi, selon un mode de réalisation préférentiel, le circuit conforme à la présente invention est un circuit hybride amplificateur large bande de signaux élec-

4

triques UHF qui comprend un filtre d'entrée formé d'une cellule asymétrique adaptée d'une part pour favoriser la transmission des signaux électriques de la bande UHF et atténuer au moins les signaux électriques de fréquence inférieure à cette bande UHF, d'autre part pour fixer l'impédance d'entrée du circuit amplificateur sur toute la bande d'utilisation, un premier étage amplificateur à transistor monté en émetteur commun et non contre-réactionné, qui est attaqué par le filtre d'entrée, un circuit de couplage connecté en sortie du premier étage amplificateur et qui comprend d'une part une capacité reliant la sortie du premier étage et la masse, et d'autre part, un circuit résonant série reliant la sortie du premier étage amplificateur et l'entrée d'un second étage amplificateur à transistor monté en émetteur commun et non contre-réactionné, ainsi qu'un filtre de sortie sensible au signal de sortie du second étage amplificateur, et formé d'une cellule asymétrique adaptée d'une part pour favoriser la transmission des signaux électriques de la bande UHF et atténuer au moins les signaux électriques de fréquence inférieure et d'autre part pour fixer l'impédance de sortie du circuit amplificateur sur toute la bande d'utilisation, et une charge réactive pour au moins l'un des étages amplificateurs.

Selon une autre caractéristique avantageuse de l'invention, les filtres d'entrée et de sortie sont des filtres du type passe haut.

Enfin, on remarquera que la présente invention concerne également les dispositifs de traitement de signaux électriques, en particulier des dispositifs de réception, par exemple de signaux de télévision, qui comprennent au moins un circuit amplificateur du type précité.

D'autres caractéristiques et avantages de la présente invention apparaîtront à la lecture de la description détaillée qui va suivre et en regard des dessins annexés sur lesquels :

- la figure 1 représente le schéma général d'un circuit amplificateur conforme à la présente invention,

- la figure 2 représente un graphe illustrant le gain (mesuré en dB) d'un circuit amplificateur conforme à la présente invention en fonction de la fréquence exprimée en MHz.

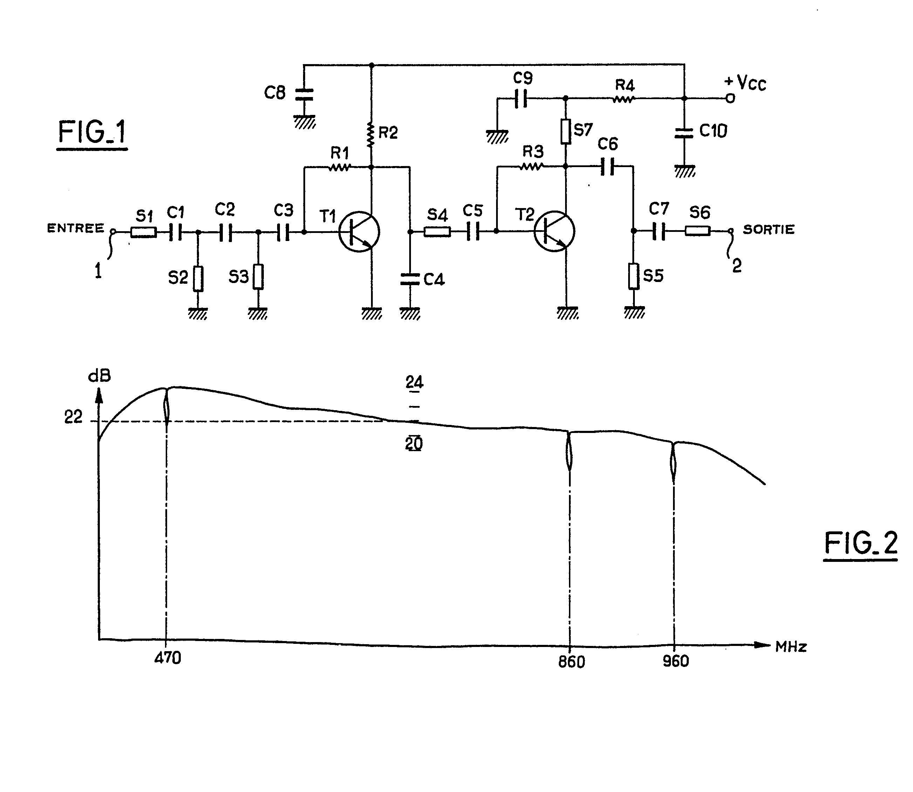

L'amplificateur représenté sur la figure 1 est destiné à amplifier des signaux de la bande UHF appliqués sur l'entrée référencée 1 et représentée sur la gauche de la figure 1, les signaux amplifiés par le circuit étant prélevés sur la sortie référencée 2 et représentée sur la droite de la figure 1. Bien entendu, les connexions d'entrée 1 et de sortie 2 seront de préférence réalisées par câble coaxial.

D'une façon générale, on reconnaît sur la figure 1 deux étages amplificateurs comportant des transistors respectifs $T_1$ et $T_2$.

Plus précisément, on aperçoit sur la figure 1 un filtre d'entrée passe haut formé de différentes cellules en T connectées en série. Ainsi, le filtre d'entrée est formé selon le mode de réalisation représenté sur la figure 1 de trois capacités référencées $C_1$, $C_2$ et $C_3$ connectées en série, par l'intermédiaire d'une self $S_1$, entre l'entrée 1 et la base d'un transistor NPN $T_1$ appartenant au premier étage amplificateur.

La self $S_1$ précitée étant connectée entre l'entrée 1 et la capacité $C_1$, une seconde self $S_2$ est connectée entre le point commun aux capacités $C_1$ et $C_2$ et la masse du montage, tandis qu'une troisième self $S_3$ est connectée entre le point commun aux capacités $C_2$ et $C_3$ et la masse du montage.

6

La self $S_1$ opère une compensation en entrant en résonance avec les capacités parasites du filtre d'entrée en fin de bande. Par ailleurs, selon l'invention, les condensateurs $C_1$, $C_2$ et $C_3$ présentent des capacités différentes pour former une cellule asymétrique.

Le filtre d'entrée ainsi formé permet d'éliminer les fréquences inférieures à la bande utilisée et d'autre part de fixer l'impédance d'entrée de l'amplificateur, dans toute la bande.

Le transistor $T_1$ appartenent au premier étage amplificateur est monté en émetteur commun, ledit émetteur étant connecté directement à la masse. Comme cela a été précédemment évoqué, ceci apporte comme avantage une augmentation importante du gain de l'étage ainsi qu'une amélioration très sensible du facteur du bruit par rapport aux propositions antérieures dans lesquelles les transistors étaient constamment contre-réactionnés.

On remarquera en effet qu'en l'absence de résistance d'émetteur, aucune contre-réaction d'intensité n'est réalisée.

De même, la contre-réaction de tension dûe à la résistance $R_1$ de très forte valeur connectée entre la base et le connecteur du transistor $T_1$ est tout à fait négligeable.

Outre la résistance $R_1$ le transistor $T_1$ est associé à une résistance $R_2$ connectée entre le collecteur de ce même transistor et la tension d'alimentation positive + VCC du montage, par exemple de 20 Volts.

Une capacité de découplage $C_8$ est prévue entre la masse du montage et la borne de la résistance $R_2$ précitée connectée à la tension positive + VCC d'alimentation.

Les deux étages à transistors $T_1$ et $T_2$ sont reliés par un circuit de couplage qui va maintenant être décrit.

7

Le circuit de couplage est constitué de deux capacités $C_4$ et $C_5$ associées à une self $S_4$. Le circuit de couplage est étudié en liaison avec l'impédance de sortie du premier étage $T_1$ et l'impédance d'entrée du second étage $T_2$ pour obtenir une bonne linéarité de l'amplificateur et assurer en particulier une limitation de l'amplification des fréquences inférieures à la bande UHF considérée.

Pour cela, la capacité $C_4$ connectée entre le collecteur du transistor $T_1$ et la masse du montage est étudiée pour présenter une impédance faible par rapport à l'impédance collecteur du transistor $T_1$, pour des signaux de fréquence inférieure à la bande UHF, afin d'atténuer ces derniers. Cependant, on remarquera que l'impédance collecteur du transistor $T_1$ évoluant très rapidement avec l'élévation de la fréquence des signaux, l'influence de la capacité $C_4$ pour des signaux de la bande UHF devient négligeable.

De plus, la self $S_4$ et la capacité $C_5$ connectées en série entre le collecteur du transistor $T_1$ et la base du transistor $T_2$ forment un circuit résonant favorisant la transmission et par conséquent l'amplification des signaux de fréquence du domaine UHF.

De façon similaire au transistor $T_1$, le transistor NPN $T_2$ du second étage est monté en émetteur commun, ce qui permet, en raison de l'absence de contre-réaction d'intensité, et de la contre-réaction de tension quasi inexistante, d'obtenir un gain très appréciable ainsi qu'un facteur de bruit nettement amélioré par rapport aux propositions antérieures.

Pour cela, bien entendu, la résistance $R_3$ connectée entre la base du transistor $T_2$ et le collecteur de celui-ci possède une valeur très grande. Le collecteur du transistor $T_2$ est chargé par une self $S_7$ reliée à la tension positive de l'alimentation + VCC par l'intermédiaire d'une résistance $R_4$.

Le point commun à la self $S_7$ et à la résistance $R_4$ est découplé à la masse du montage par l'intermédiaire d'une capacité $C_9$. La valeur de la self $S_7$ est déterminée en liaison avec les capacités parasites du montage pour former un circuit résonant dont la fréquence de résonance est située dans le domaine supérieur de la bande de fréquences UHF retenue. Ainsi, cette charge selfique $S_7$, en liaison avec les capacités parasites inhérentes au montage permet une optimisation du gain aux fréquences élevées de la bande, comme cela ressort en particulier de la figure 2 annexée.

La tension positive d'alimentation + VCC est également découplée à la masse grâce à une capacité $C_{10}$.

Enfin, le filtre de sortie est constitué des selfs $S_5$ et $S_6$ associées aux capacités $C_6$ et $C_7$.

Plus précisément, le filtre de sortie est formé d'une cellule en T comprenant une branche constituée des capacités $C_6$ et $C_7$ connectées en série entre le collecteur du transistor $T_2$ et, par l'intermédiaire de la self $S_6$, la borne de sortie 2, d'une part, et la self $S_5$ connectée entre le point commun aux capacités $C_6$ et $C_7$ et la masse d'autre part.

Là encore, selon l'invention, les condensateurs $C_6$ et $C_7$ possèdent des capacités différentes pour former une cellule asymétrique.

De façon similaire au filtre d'entrée, le filtre de sortie permet d'éliminer les fréquences inférieures à la bande utilisée et d'autre part de fixer l'impédance de sortie de l'amplificateur dans toute la bande.

Selon le mode de réalisation représenté et considéré comme préférentiel, les filtres d'entrée et de sortie sont des filtres passe-haut, bien entendu, en variante, des filtres passe-bande pourraient également être retenus.

Les domaines d'application du circuit amplificateur conforme à la présente invention sont notamment la réception et le traitement des signaux de la bande UHF (470-960 Mhz).

Un mode de réalisation particulier à deux étages amplificateurs, d'un circuit conforme à la présente invention, a permis d'obtenir les performances suivantes :

- gain : 22 dB $\pm$ 2 dB dans la bande 470-860 Mhz (comme cela est représenté sur la figure 2),

- facteur de bruit : F < 2,8 dB,

- niveau de sortie : 107 dB µVa - 52 dB d'intermodulation d'ordre 3 (mesuré à trois porteuses dont deux atténuées de 6 dB).

Bien entendu, la présente invention n'est pas limitée au mode de réalisation décrit mais s'étend à toute variante conforme à son esprit, en particulier on notera qu'un nombre d'étages différent de deux est susceptible d'être retenu.

On remarquera par ailleurs que, en raison de la structure du circuit proposé, tous les éléments selfiques présentent des impédances relativement faibles ce qui autorise la réalisation de ces éléments selfiques sous forme de circuits imprimés. De ce fait, selon une caractéristique très importante de la présente invention, le circuit amplificateur est réalisé sous forme de technologie hybride. Outre des caractéristiques de gain et de linéarité exceptionnelles, la présente invention permet ainsi d'obtenir un facteur de bruit très proche de celui annoncé par les constructeurs pour les transistors.

Selon un mode de réalisation non limitatif réalisé en technologie hybride, qui a été testé par la Demanderesse :

10

- les transistors $T_1$ et $T_2$ sont des transis-tors BFR 93 A commercialisés par RTC,

- les condensateurs $C_1$ à $C_{10}$ ont les valeurs suivantes :

$$C_1 \qquad = 5,6 \text{ pF}$$
$$C_2 \text{ et } C_4 = 4,7 \text{ pF,}$$
$$C_3 \text{ et } C_6 = 3,9 \text{ pF,}$$
$$C_5 \qquad = 2,7 \text{ pF,}$$
$$C_7 \qquad = 4,7 \text{ pF,}$$
$$C_8, \; C_9 \text{ et } C_{10} = 1\,000 \text{ pF.}$$

- les résistances $R_1$ à $R_4$ réalisées sur le circuit imprimé ont les valeurs suivantes :

$$R_1 \text{ et } R_3 = 18 \text{ k } \Omega$$
$$R_2 \qquad = \; 1 \text{ k } \Omega$$
$$R_4 \qquad = 560 \quad \Omega$$

- les selfs réalisées également sur le circuit imprimé sont déterminées sur la base des valeurs précitées des composants et en fonction notamment des capacités parasites du circuit.

11

REVENDICATIONS

1. Circuit amplificateur large bande de signaux électriques UHF caractérisé par le fait qu'il comprend :
- au moins deux étages amplificateurs à transistors ($T_1$, $T_2$) non contre-réactionnés,
- un filtre d'entrée ($S_2$, $S_3$, $C_1$, $C_2$, $C_3$) et
- un filtre de sortie ($C_6$, $C_7$, $S_5$), lesdits filtres étant adaptés pour favoriser la transmission des signaux électriques de la bande UHF et atténuer au moins les signaux électriques de fréquence inférieure à cette bande UHF et les filtres d'entrée et de sortie étant des cellules asymétriques qui fixent respectivement l'impédance d'entrée et de sortie du circuit amplificateur sur toute la bande d'utilisation.

2. Circuit amplificateur selon la revendication 1, caractérisé par le fait que les transistors ($T_1$, $T_2$) des étages amplificateurs sont montés en émetteur commun.

3. Circuit amplificateur selon l'une des revendications 1 à 2, caractérisé par le fait que l'un au moins des étages amplificateurs ($T_2$) comporte une charge réactive ($S_7$).

4. Circuit amplificateur selon l'une des revendications 1 à 3, caractérisé par le fait qu'il est prévu un circuit de couplage entre les deux étages amplificateurs ($T_1$, $T_2$),qui comprend une capacité ($C_4$) reliant la sortie de l'étage ($T_1$) attaqué par le filtre d'entrée ($C_1$, $C_2$, $C_3$, $S_2$, $S_3$) et la masse, et un circuit résonant série ($S_4$, $C_5$) connecté entre la sortie de l'étage ($T_1$) attaqué par le filtre d'entrée et l'entrée de l'autre étage amplificateur ($T_2$).

5. Circuit amplificateur selon l'une des revendications 1 à 4, caractérisé par le fait qu'il est réalisé en technologie hybride.

12

6. Circuit hybride amplificateur large bande de signaux électriques UHF selon la revendication 5, caractérisé par le fait qu'il comprend :
- au moins deux étages amplificateurs à transistors ($T_1$, $T_2$) non contre-réactionnés,
- un filtre d'entrée ($C_1$, $C_2$, $C_3$, $S_2$, $S_3$),et
- un filtre de sortie ($C_6$, $C_7$, $S_5$), lesdits filtres étant adaptés pour favoriser la transmission des signaux électriques de la bande UHF et atténuer au moins les signaux électriques de fréquence inférieure à cette bande UHF et les filtres d'entrée et de sortie étant des cellules asymétriques qui fixent respectivement l'impédance d'entrée et de sortie du circuit amplificateur sur toute la bande d'utilisation.

7. Circuit hybride amplificateur large bande de signaux électriques UHF selon l'une des revendications 5 et 6, caractérisé par le fait qu'il comprend :
- un filtre d'entrée ($C_1$, $C_2$, $C_3$, $S_2$, $S_3$) formé d'une cellule asymétrique adaptée d'une part pour favoriser la transmission des signaux électriques de la bande UHF et atténuer au moins les signaux électriques de fréquence inférieure à cette bande UHF, d'autre part pour fixer l'impédance d'entrée du circuit amplificateur sur toute la bande d'utilisation,
- un premier étage amplificateur à transistor ($T_1$) monté en émetteur commun et non contre-réactionné qui est attaqué par le filtre d'entrée,
- un circuit de couplage connecté en sortie du premier étage amplificateur et qui comprend une capacité ($C_4$) reliant la sortie du premier étage ($T_1$) et la masse, et un circuit résonant série ($S_4$, $C_5$) reliant la sortie du premier étage amplificateur et l'entrée
- d'un second étage amplificateur à transistor ($T_2$) monté en émetteur commun et non contre-réactionné ainsi que

13

- un filtre de sortie ($C_6$, $C_7$, $S_5$) sensible au signal de sortie du second étage amplificateur et formé d'une cellule asymétrique, adaptée d'une part pour favoriser la transmission des signaux électriques de la bande UHF et atténuer au moins les signaux électriques de fréquence inférieure, d'autre part pour fixer l'impédance de sortie du circuit amplificateur sur toute la bande d'utilisation, et

- une charge réactive ($S_7$) pour au moins l'un des étages amplificateurs ($T_1$, $T_2$).

8. Circuit amplificateur selon l'une des revendications 1 à 7, caractérisé par le fait que les filtres d'entrée et de sortie sont des filtres de type passe-haut.

9. Dispositif de traitement de signaux électriques, en particulier dispositif de réception, caractérisé par le fait qu'il comprend au moins un circuit amplificateur conforme à l'une des revendications 1 à 8.

**FIG.1**

ENTREE 1

**FIG.2**

dB

# RAPPORT DE RECHERCHE EUROPEENNE

**Office européen des brevets**

0146429
Numéro de la demande

EP 84 40 2204

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y | FR-A-2 355 398 (FUJITSU LTD.)<br><br>* Figures 2a-3b; page 3, lignes 27-39; page 5, ligne 23 - page 7, ligne 23 *<br><br>--- | 1-3,5, 6,8,9 | H 03 F 3/19 |
| Y | TOUTE L'ELECTRONIQUE, no. 398, avril 1975, pages 49-53, Paris, FR; J.M: ZULAUF: "U.H.F. à transistors"<br>* Figure 2; page 50, paragraphe: "Amplificateur d'antenne à large bande à trois étages (20 à 860 MHz)", lignes 1-41 * | 1-3,5, 6,8,9 | |
| A | Idem | 4,7 | |
| | --- | | **DOMAINES TECHNIQUES RECHERCHES (Int. Cl.4)** |
| A | INSTITUTE OF ELECTRICAL AND ELECTRONICS ENGINEERS. NORTHEAST ELECTRONICS RESEARCH AND ENGINEERING MEETING, NEREM RECORD 1965, pages 126-127, publié par E.E. Witschi Jr. Newton, Massachusetts, US; W.J. PENDERGAST et al.: "The design of thin film lumped element UHF amplifiers"<br>* Figure 1; page 126, colonne de gauche, lignes 1-41 *<br><br>----- | 1,2,4, 6 | H 03 F |

Le présent rapport de recherche a été établi pour toutes les revendications

| Lieu de la recherche | Date d'achèvement de la recherche | Examinateur |
|---|---|---|
| LA HAYE | 21-02-1985 | TYBERGHIEN G.M.P. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03 82